Europäisches Patentamt

European Patent Office

Office européen des brevets

(11) Publication number: **0 087 438**
**B1**

## EUROPEAN PATENT SPECIFICATION

(45) Date of publication of patent specification: 29.04.87

(51) Int. Cl.⁴: **G 01 R 19/04**, G 01 R 13/34 // H01J31/60

(21) Application number: 82902634.3

(22) Date of filing: 07.09.82

(86) International application number: PCT/AU82/00149

(87) International publication number: WO 83/00933 17.03.83 Gazette 83/07

(54) SIGNAL SAMPLING AND CONVERSION SYSTEM.

(30) Priority: 07.09.81 AU 623/81
18.09.81 AU 817/81

(43) Date of publication of application:
07.09.83 Bulletin 83/36

(45) Publication of the grant of the patent:
29.04.87 Bulletin 87/18

(84) Designated Contracting States:
DE FR GB

(56) References cited:
EP-A-0 006 779
DE-A-2 147 495
FR-A-2 331 794
US-A-3 958 210
US-A-4 166 956

(73) Proprietor: SPALDING, David Ian
45A Blackett Drive
Castle Hill, N.S.W. 2154 (AU)

(72) Inventor: SPALDING, David Ian
45A Blackett Drive
Castle Hill, N.S.W. 2154 (AU)

(74) Representative: Rooney, Paul Blaise et al
D.Young & Co. 10 Staple Inn
London WC1V 7RD (GB)

Courier Press, Leamington Spa, England.

## Description

This invention relates to a signal sampling and conversion system and in particular to a system which is suitable for the high-frequency sampling of either recurrent or non-recurrent signals, in applications where the subsequent processing of the acquired samples needs to be performed at relatively low frequencies as, for example, in analogue-to-digital conversion systems.

Many techniques for the analysis or recording of a signal waveform require that a plurality of time-referenced samples of the waveform be stored in the form of digitally-encoded words for subsequent processing. It is, however, known to be difficult to encode, or quantize, samples at a high rate, particularly when high accuracy is required simultaneously. It is known for example to achieve a maximum sample-quantizing rate of 20 MHz with a resolution of 1 part in 1024 (10 binary bits).

According to the well-known Nyquist-limit condition it is necessary, in a real-time sampling system, for the sampling frequency to be at least twice that of the highest-frequency component of the signal being sampled. For very-high-frequency signals it is usual, therefore, to employ the techniques of random or sequential sampling, in each of which a continuously-recurring signal is sampled at a frequency below that of the signal and a complete set of waveform samples is accumulated over a period containing many signal cycles. Neither of the latter techniques, however, is applicable to non-recurring signals.

It is known in an alternative system to store signal samples in a form of charge-transfer device, for example a CCD integrated-circuit analogue shift-register. One such device allows 250 signal samples to be acquired serially at a rate of up to 50 MHz and transferred out at a conveniently lower rate. This technique is suitable for both recurrent and non-recurrent signals but has the disadvantage of being limited in sample acquisition-rate by the charge-transfer device characteristics.

In previously-known sample-and-hold systems, a sample of a signal is acquired by charging a storage capacitor for the duration of a sample period to a voltage which will be as nearly as possible equal in magnitude to the instantaneous voltage of the said signal at the end of the sample period. The capacitor current in the sample period is a function of the instantaneous difference between the signal and capacitor voltages. The sample period must therefore be long enough to allow the said difference in voltages to reach an acceptably low level, when the signal voltage is static, before the capacitor is isolated from the charging circuit for the hold period. This sample-and-hold cycle may be repeated in response to timing pulses.

It will be apparent to those skilled in the art that if the signal to be sampled changes in magnitude during a sample period, the resulting sample may not be a true representation of the signal magnitude at the end of the sample period. In particular, the storage capacitor voltage will lag the signal voltage; irregularity in the timing of sample pulses combined with the sample-hold transition time will cause uncertainty of the signal voltage at the end of the sample period; random noise of higher frequency than the sample rate will cause random sample voltage errors; and in general, neither the signal voltage at the end of the sample period nor the resulting sample voltage will be representative of the signal voltages occurring prior to the end of the sample period.

Some previously-proposed solutions to the problem of high-speed sampling involve the use of a cathode-ray tube (CRT) incorporating a semiconductor integrated-circuit target to detect, and store charge from, the impact of the electron beam. These devices are of two distinct types:

the first type employing deflection of the electron beam by application of the signal to the Y deflection plates of the tube;

the second type using amplitude modulation of the electron beam by application of the signal between control grid and cathode of the electron gun.

In both types the electron beam is made to scan across the target by application of a time-base linear ramp signal to the X deflection plates.

In the first type of CRT device, deflection of the electron beam by the input signal results in charge generation in the target at a Y position which is related in a substantially linear manner to the instantaneous amplitude of the input signal. The target is typically a rectangular mosaic of elementary detectors combined in a single integrated circuit with a system of CCD shift registers for charge readout. Advantages of this type are that:

the applied signal and the target may both be ground-referenced;

and the samples obtained are independent of electron-beam current or noise.

Disadvantages include:

the extremely high cost of the large target integrated circuits typically having around 200,000 detector elements;

the presence of geometric distortion because of the two-dimensional scan system;

and the limited resolution and system bandwidth which, together with writing speed, are design compromises related to integrated-circuit size.

In the second type of CRT device, an example of which is described in French patent document FR—A—2 331 794, figure 1 of that document, charges are generated in a linear array of target elements in response to the impact of the electron beam, the amplitude of the charges being dependent on the instantaneous signal amplitude.

Advantages of this type of device are:

that the target is simple and low in cost; that the maximum writing speed is higher than with a two dimensional target making faster sampling possible;

that stored samples may be read out quickly, minimising the delay between scans;

that stored samples represent an unambiguous time integral of the input signal during each sample interval, which is useful for noisy signals.

Disadvantages, however, are apparent:

the relationship between stored samples and the input signal is non-linear;

the input is referenced to a high potential, −5 to −10kv typically, which, together with the large signal amplitude requirement, presents practical difficulties in the application of signals with d.c. components and/or very high frequencies;

electron beam current fluctuation is indistinguishable from the signal modulation, affecting resolution or dynamic range;

and the signal gain may vary with tube bias conditions, which generally need to be changed for different time-base scan rates.

The present invention differs from each of the two preceding systems but combines the advantages of both said systems, whilst substantially overcoming their disadvantages.

According to the present invention there is provided a signal sampling and conversion system comprising:

an electron gun operable as a controlled-current source to generate an electron beam convergent upon a target, a time-base deflector means operable to scan the electron beam across the target in a direction generally parallel to a median line, the target comprising a plurality of electron beam detector elements distributed along the median line, electrons incident on the detector elements generating charges therein which are retained in storage means associated with the detector elements whereby the stored charges can be used to provide output signals representative of an input signal modifying the electron beam,

characterised in that an input-signal deflector means is operable to deflect the electron beam orthogonally from the median line according to the instantaneous value of the input signal, and the detector elements are shaped such that the dimension parallel to the median line of the area exposed to the electron beam of each detector element varies as a specified function of the perpendicular distance from the median line resulting in the charge generated in the detector element and converted to an output signal by a converter during an electron beam scan being a similar specified function of the displacement of the electron beam orthogonally from the median line.

Although the preferred embodiment of the present invention incorporates a linear detector element array in the form of an integrated circuit located at the focal plane of an electron beam, it is operable according to the principle of deflection modulation; that is to say, the signal to be sampled is applied to the Y deflection plates of the CRT and the amount of charge generated in a detector element during a scan is a specified function of the Y displacement of the electron beam, which displacement is linearly proportional to the input signal to a first order. This modulation is accomplished by suitably shaping the detector elements so as to vary the time of integration of the electron-beam energy incident on a detector element according to the Y deflection of the electron beam during its transit over that element. The electron-beam current and accelerating voltage are maintained constant during a scan.

This time integration system has the major advantage that a precisely-defined transfer function is obtainable which is substantially independent of electron beam irregularities.

The preferred embodiment employs charge-transfer integrated circuits, particularly of the CCD type, essentially comprising a plurality of analogue shift register elements with large dynamic range operable to transport charges accumulated by a plurality of photon-detecting elements. However, the said photon-detecting elements may be adapted to accumulate electrons by conduction from supplementary electrodes or other circuit connections, photons being preferably excluded. Thus a CCD integrated circuit may comprise the storage means and output converter of the present invention.

In order to maximise the attainable sample rate and signal frequency bandwidth, it is advantageous to use a CRT which is constructed according to known principles and practice so that a CCD integrated circuit can be positioned in the focal plane of its electron beam. The CCD integrated circuit may feature a target array as part of the commutation means. The CRT system including the said CCD integrated circuit is operable in conjunction with related external circuits as the signal sampling and conversion system.

Embodiments of the present invention will now be described with reference to the accompanying drawings, in which:

Figure 1 is a perspective schematic view of a signal sampling and conversion system in accordance with an embodiment of the present invention;

Figure 2 is a diagram showing a representative portion of a basic form of target and manner of connection thereto of signal conversion circuits useful for understanding the present invention; and

Figure 3 is a diagram of modification to part of the arrangement of Figure 2 showing a target arrangement according to an embodiment of the invention.

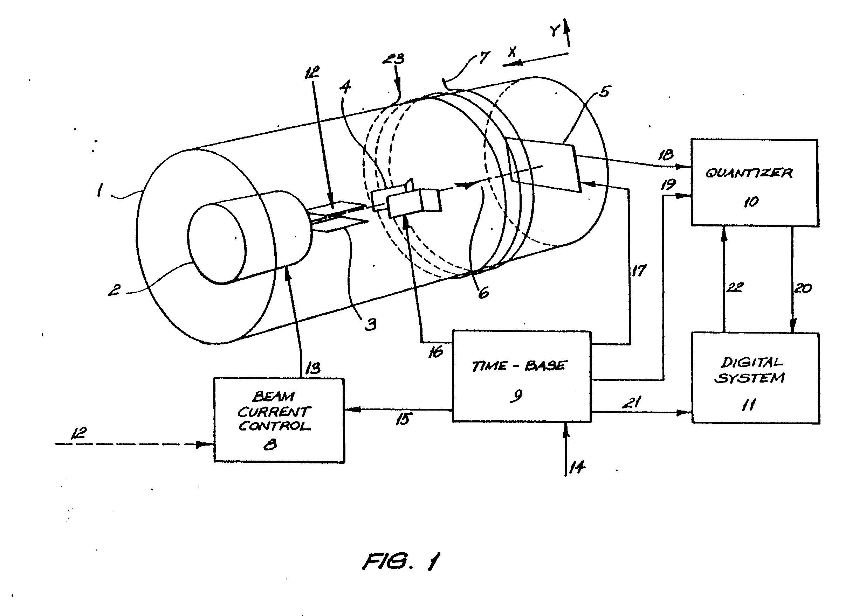

There is shown in Figure 1 a signal sampling and conversion system comprising a CRT 1 having at one end an electron gun assembly 2 generating a current in the form of electron beam 6, the amplitude of said current being in accordance with control signals 13; a Y axis deflection plate assembly 3; an X axis deflection plate assembly 4 causing the beam 6 to be deflected, or scanned, in an X direction across the surface of a CCD integrated circuit target 5 in response to a timing ramp voltage 16; a scan rotation coil 7 carrying an alignment current 23; a beam current control circuit 8 generating control signals 13 in response to timebase sweep speed and timing signals 15: a timebase 9 generating digital timing and control signals 15, 17, 19 and 21 and the ramp voltages 16 in response to a trigger signal 14; a quantizer 10 encoding serial analogue data 18 from the CCD integrated circuit 5 in response to timing signals 19 and stored reference data 22; and a digital system 11 which in general is adapted to suit a particular application of the apparatus but in particular is adapted to receive and store digitally-encoded signals 20 in response to timing signals 21, said digitally-encoded signals being inclusive of calibration data which is subsequently re-transmitted to the quantizer 10 as reference data 22. A signal input 12 may be applied alternatively to modulate the beam current through the beam current control 8, as shown by a dashed arrow, or to the Y deflection plates 3.

In a basic form of the apparatus, useful for understanding the invention, the integrated circuit 5 carries a linear array of approximately 500 conductive target elements 24, as shown in Figure 2, each of the said elements being attached to a storage element 25. When a trigger impulse 14 is applied the electron beam 6 is set to a predetermined bias current and caused to sweep across the target elements 24 along a straight path 32. The length of the target elements in the Y direction is made sufficient to accommodate any anticipated misalignment of the sweep. The beam is blanked during the retrace time, according to normal practice. The beam current is modulated during the sweep by applying the input signal 12 to the beam current control 8, the Y deflection plates 3 being grounded or omitted. Charge samples thus acquired by the storage elements 25 are subsequently transferred by a CCD transfer gate 26 in response to a transfer pulse 29 to a shift register consisting of approximately 500 CCD stages 27. The samples 30 are then shifted sequentially in response to timing signals 34 to a conventional charge detector amplifier 28 which produces an output voltage signal 31 proportional to the amplitude of each corresponding charge sample. Although a single shift register is shown for clarity, it is common practice to couple the storage elements 25 alternatively to two parallel registers. In like manner, further registers and elements may be included for ancillary purposes.

Two disadvantages of the arrangement shown in Figure 2 are that the non-linearity of the beam current modulation system necessitates the use of complex correction and calibration circuits, and the presence of a high beam acceleration potential on the electrodes of the gun 2 makes the coupling of an input signal difficult, particularly if the signal components extend to a low or zero frequency.

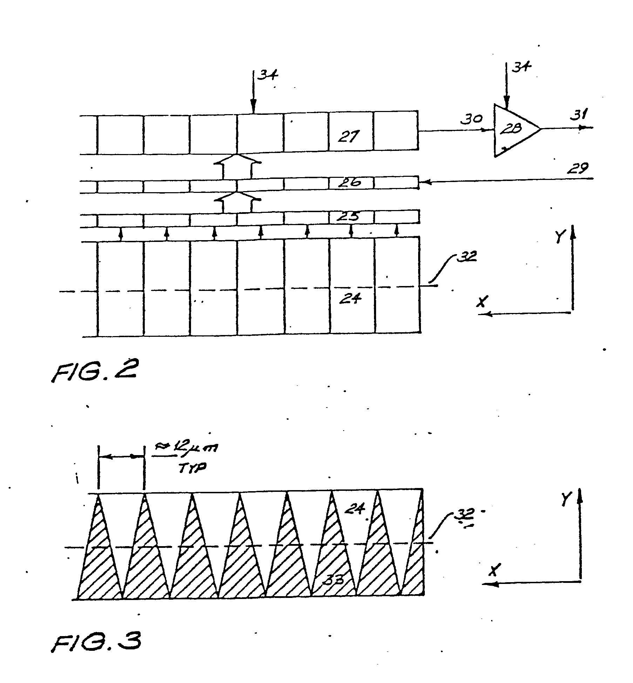

In the preferred embodiment of the invention, illustrated in Figure 3, the CCD is provided with a modified target array intended to eliminate the disadvantages of the Figure 2 arrangement. The target elements 24 of the embodiment are triangular in shape, the Y dimension being approximately 1 mm. Between target elements there are placed grounded conductive elements 33. For a constant beam current during a scan, the charge acquired by an element 24 is thus linearly related to the displacement in the Y direction of the electron beam from the median line 32. The input signal in this case is applied to the Y plates, which are close to ground potential, and a linear relationship between the input signal 12 and the output 18 is thus readily achieved.

Major advantages of the Figure 3 arrangement are that the sensitivity of the Y plates is very high because of the small vertical deflection, and very wide signal bandwidth is readily achievable using well-known CRT techniques. However, precise scan alignment is necessary and an alignment current 23 is therefore applied to the scan rotation coil 7 for skew correction whilst Y position is corrected by summing a d.c. offset voltage with the input signal 12.

The foregoing is a description of only the preferred embodiment of the present invention. For example, the number and size of target elements may be varied, in conjunction with corresponding changes to the storage and conversion elements, to satisfy different time and amplitude resolution requirements.

The advantages of the preferred embodiment include the ability to acquire and store a plurality of samples of a signal during a selected time interval; to convert said stored samples to one or more serial outputs having an analogue data rate suitable for quantization or other processing of the data; to achieve the sampling and conversion of very-high-frequency signals by a compact, economical, reliable and accurate means; to reduce sampling errors caused by unwanted noise or frequency components higher than the sampling rate; to reduce relative timing errors of samples; to virtually eliminate sampling errors caused by rapid transitions of the signal; and to provide a sample storage system permitting the average voltage of the signal during each sample period to be readily quantized.

**Claims**

1. A signal sampling and conversion system comprising:

an electron gun (2) operable as a controlled-current source to generate an electron beam (6) convergent upon a target (5), a time-base deflector means (9) operable to scan the electron beam (6) across the target (5) in a direction generally parallel to a median line (32), the target (5) comprising a plurality of electron beam detector elements (24) distributed along the median line (32), electrons incident on the detector elements (24) generating charges therein which are retained in storage means (25) associated with the detector elements (24) whereby the stored charges can be used to provide output signals representative of an input signal modifying the electron beam (6),

characterised in that an input-signal deflector means (3) is operable to deflect the electron beam (6) orthogonally from the median line (32) according to the instantaneous value of the input signal, and the detector elements (24) are shaped such that the dimension parallel to the median line (32) of the area exposed to the electron beam (6) of each detector element (24) varies as a specified function of the perpendicular distance from the median line (32) resulting in the charge generated in the detector element (24) and converted to an output signal by a converter (27, 28) during an electron beam scan being a similar specified function of the displacement of the electron beam (6) orthogonally from the median line (32).

2. A system according to claim 1, wherein the target (5) includes a second plurality of elements (33) each complementary to and covering substantially the area between adjacent detector elements (24) so as to collect substantially all of that portion of the electron beam (6) not impinging on the detector elements (24).

3. A system according to claim 1 or claim 2, wherein the second plurality of elements (33) are grounded.

4. A system according to claim 1, claim 2 or claim 3, wherein the detector elements (24) are triangular shaped.

5. A system according to any one of the preceding claims, wherein the converter (27, 28) is of the type which removes the charges and generates output signals representing the amplitude of each of the charges in a sequential manner.

6. A system according to any one of the preceding claims, wherein the converter (27, 28) comprises a charge transfer circuit.

7. A system according to any one of the preceding claims, wherein the storage means (25) is part of a semiconductor integrated circuit (5) which includes a charge coupled device (CCD).

**Patentansprüche**

1. Signalabtastungs- und Umsetzungssystem
mit einer Elektronenkanone (2), die als eine gesteuerte Stromquelle betreibbar ist, um einen auf eine Auftreffplatte (5) zusammenlaufenden Elektronenstrahl (6) zu erzeugen, einem Ablenkmittel (9) auf Zeitbasis, welches betrieben werden kann, um den Elektronenstrahl (6) über die Auftreffplatte (5) in einer Richtung im allgemeinen parallel zu einer Mittellinie (32) abzutasten, wobei die Auftreffplatte (5) eine Mehrzahl von Elektronenstrahldetektorelementen (24) aufweist, die längs der Mittellinie (32) verteilt sind, die auf die Detektorelemente (24) auftreffenden Elektronen Ladungen in diesen erzeugen, die in Speichermitteln (25) gehalten werden, welche den Detektorelementen (24) zugeordnet sind, und wobei die gespeicherten Ladungen verwendet werden können, um Ausgangssignale vorzusehen, die für ein den Elektronenstrahl (6) modifizierendes Eingangssignal repräsentativ sind,
dadurch gekennzeichnet, daß ein Eingangssignaldeflektormittel (3) betrieben werden kann, um den Elektronenstrahl (6) senkrecht zur Mittellinie (32) gemäß dem Augenblickswert des Eingangssignals abzulenken, und die Detektorelemente (24) derart gestaltet sind, daß die Abmessung parallel zur Mittellinie (32) für jedes Detektorelement (24) derjenigen Fläche, welche dem Elektronenstrahl (6) ausgesetzt ist, in einer konkreten Funktion des senkrechten Abstandes von der Mittellinie (32) variiert, der sich in der Ladung auswirkt, die in dem Detektorelement (24) erzeugt wird, und von einem Umsetzer (27, 28) in ein Ausgangssignal während einer Elektronenstrahlabtastung umgesetzt wird, wobei die Ladung eine ähnliche konkrete Funktion der Verschiebung des Elektronenstrahles (6) senkrecht aus der Mittellinie (32) ist.

2. System nach Anspruch 1, wobei die Auftreffplatte (5) eine zweite Vielzahl von Elementen (33) aufweist, die jeweils zu der Fläche zwischen benachbarten Detektorelementen (24) komplementär ist und diese im wesentlichen abdeckt, um im wesentlichen den gesamten Teil des Elektronenstrahles (6) zu sammeln, der nicht auf die Detektorelemente (24) auftrifft.

3. System nach Anspruch 1 oder Anspruch 2, wobei die zweite Vielzahl von Elementen (33) geerdet ist.

4. System nach Anspruch 1, Anspruch 2 oder Anspruch 3, wobei die Detektorelemente (24) dreieckförmig sind.

5. System nach einem der vorhergehenden Ansprüche, wobei der Umsetzer (27, 28) von demjenigen Typ ist, welcher die Ladungen entfernt und Ausgangssignale erzeugt, welche die Amplitude jeder Ladung in einer Folge darstellen.

6. System nach einem der vorhergehenden Ansprüche, wobei der Umsetzer (27, 28) eine Ladungsübertragungsschaltung aufweist.

7. System nach einem der vorhergehenden Ansprüche, wobei das Speichermittel (25) Teil einer integrierten Halbleiterschaltung (5) ist, welche eine ladungsgekoppelte Vorrichtung (CCD = Ladungsspeicherelement) aufweist.

**Revendications**

1. Système d'échantillonnage et de conversion de signal comprenant
un canon à électrons (2) agissant en source à courant contrôlé pour générer un faisceau électronique (6) convergeant sur une cible (5), un moyen déflecteur de base de temps (9) faisant balayer la cible (5) par le faisceau électronique (6) suivant une direction générale parallèle à une ligne médiane (32), la cible (5) comprenant une série déléments détecteurs de faisceau électronique (24) répartis le long de la ligne médiane (32), les électrons atteignant les éléments détecteurs (24) y engendrant des charges qui sont retenues dans des moyens de stockage (25) associés aux éléments détecteurs (24) de sorte que les charges stockées peuvent servir à fournir des signaux de sortie représentatifs d'un signal d'entrée modifiant le faisceau électronique (6),
caractérisé en ce qu'un moyen déflecteur de signal d'entrée (3) agit pour dévier le faisceau électronique (6) perpendiculairement à la ligne médiane (32) suivant la valeur instantanée du signal d'entrée, et les éléments détecteurs (24) sont conformés en sorte que la dimension parallèle à la ligne médiane (32) de l'aire exposée au faisceau électronique (6) de chaque élément détecteur (24) varie en fonction spécifiée de la distance orthogonale à la ligne médiane (32) ce qui fait que la charge engendrée dans l'élément détecteur (24) et convertie en un signal de sortie par un convertisseur (27, 28) pendant un balayage par le faisceau électronique est une fonction spécifiée analogue du déplacement du faisceau électronique perpendiculairement à la ligne médiane (32).

2. Système selon la revendication 1, dans lequel la cible (5) comporte une seconde série d'éléments (33) dont chacun est complémentaire à, et recouvre sensiblement l'aire entre, des éléments détecteurs voisins (24) de façon à recueillir la quasi-totalité de la partie du faisceau électronique (6) qui ne tombe pas sur les éléments détecteurs (24).

3. Système selon la revendication 1 ou la revendication 2, dans lequel la seconde série d'éléments (33) sont mis à la terre.

4. Système selon la revendication 1, 2 ou 3, dans lequel les éléments détecteurs (24) sont de forme triangulaire.

5. Système selon l'une quelconque des revendications précédentes, dans lequel le convertisseur (27, 28) est du type qui élimine les charges et engendre des signaux de sortie représentant l'amplitude de chacune des charges de manière séquentielle.

6. Système selon l'une quelconque des revendications précédentes, dans lequel le convertisseur (27, 28) est constitué par un circuit de transfert de charge.

7. Système selon l'une quelconque des revendications précédentes, dans lequel le moyen de stockage (25) fait partie d'un circuit intégré à semi-conducteurs (5) qui comporte un dispositif à couplage de charge (CCD).

FIG. 1

0 087 438

FIG. 2

FIG. 3